Europäisches Patentamt

European Patent Office

Office européen des brevets

(19)

(11) Numéro de publication : **0 078 188**
**B1**

(12) **FASCICULE DE BREVET EUROPÉEN**

(45) Date de publication du fascicule du brevet :
12.02.86

(51) Int. Cl.⁴ : **H 03 B 19/18**

(21) Numéro de dépôt : 82401856.8

(22) Date de dépôt : 08.10.82

(54) **Dispositif hyperfréquence à large bande générateur des harmoniques d'ordre pair d'un signal incident, et utilisation d'un tel dispositif dans un système hyperfréquence.**

(30) Priorité : 23.10.81 FR 8119939

(43) Date de publication de la demande :
04.05.83 Bulletin 83/18

(45) Mention de la délivrance du brevet :
12.02.86 Bulletin 86/07

(84) Etats contractants désignés :
DE GB IT

(56) Documents cités :
GB-A- 1 152 113
US-A- 3 678 395
IEEE TRANSACTIONS ON MTT, vol. 28, no. 3, mars 1980, pages 180-185, New York (USA); H. OGAWA et al.: "K-band integrated double balanced mixer"
PATENTS ABSTRACTS OF JAPAN, vol. 5, no. 55, 16 avril 1981, page 727E52;
RADIO AND ELECTRONICS ENGINEER, vol. 48, no. 1/2, janvier/février 1978, pages 29-32, Londres (GB); J. KOHLER et al.: "Broadband microwave frequency doubleurs"

(73) Titulaire : **THOMSON-CSF**
**173, Boulevard Haussmann**
**F-75379 Paris Cedex 08 (FR)**

(72) Inventeur : **Houdart, Michel**
**THOMSON-CSF SCPI 173, bld Haussmann**
**F-75379 Paris Cedex 08 (FR)**
Inventeur : **Arrubarrena, Edouard**
**THOMSON-CSF SCPI 173, bld Haussmann**
**F-75379 Paris Cedex 08 (FR)**
Inventeur : **Maurette, Frédéric**
**THOMSON-CSF SCPI 173, bld Haussmann**
**F-75379 Paris Cedex 08 (FR)**

(74) Mandataire : **Benoit, Monique et al**
**THOMSON-CSF SCPI 173, Bld Haussmann**
**F-75379 Paris Cedex 08 (FR)**

Jouve, 18, rue St-Denis, 75001 Paris, France

# 0 078 188

### Description

La présente invention concerne un dispositif hyperfréquence à large bande, générateur des harmoniques d'ordre pair d'un signal incident et son utilisation dans un système hyperfréquence.

Un circuit doubleur de fréquence constitue un cas particulier du circuit faisant l'objet de cette demande. On en connaît plusieurs modes de réalisation, parmi lesquels :

les doubleurs utilisant un duplexeur de fréquence :

Le signal dont on veut doubler la fréquence est injecté dans la sortie voie basse, correspondant au filtre passe-bas, aiguillé sur la voie commune comprenant un élément non linéaire, tel que diode Schottky. La sortie voie haute du duplexeur délivre alors les harmoniques générés par l'élément non linéaire. La réjection des harmoniques d'ordre impair est réalisée par filtrage en sortie du filtre passe-haut du duplexeur. Ce filtrage constitue l'un des principaux inconvénients de ce type de doubleur puisqu'il en limite la bande de fonctionnement. Les pertes d'insertion du circuit duplexeur altèrent de plus grandement le rendement de conversion ;

les doubleurs utilisant un mélangeur :

Le signal fondamental alimente l'entrée d'un diviseur de puissance, dont les deux sorties, de fréquence identique, sont appliquées aux entrées dites « Oscillateur local » et « signal » d'un mélangeur. La sortie dite « fréquence intermédiaire » du mélangeur délivre alors entre autre un signal de fréquence égale à la somme des fréquences des signaux d'entrée donc de fréquence double du signal fondamental incident.

Le circuit composé de l'association d'un diviseur de puissance et d'un mélangeur constitue donc bien un doubleur de fréquence. Mais il présente certains inconvénients. Il est en effet indispensable d'utiliser un mélangeur possédant une très bonne réjection des harmoniques d'ordre 2 entre l'entrée dite « Oscillateur local » et la sortie du mélangeur afin de pouvoir isoler le signal dont la fréquence correspond à la somme $f_{oL} + f_s$ des fréquences d'entrée. De plus il est dificile de réaliser des mélangeurs dont les entrées présentent des largeurs de bande suffisamment grandes pour assurer en sortie une couverture de fréquence convenable

les doubleurs du type dissymétrique/symétrique ou symétrique/dissymétrique : Ce type de doubleur a été décrit dans un article de MM. J. KOHLER et B. SCHIECK paru dans « The Radio and Electronic Engineer », Vol. 48, N° 1/2, Janvier/Février 1978, pages 29-32 et intitulé « Broadband microwave frequency doublers ».

Dans cet article il est décrit un doubleur symétrique-dissymétrique qui comprend un diviseur constitué par une ligne microstrip, suivi d'un déphaseur constitué par des prolongements de cette ligne, les terminaisons de cette ligne à propagation symétrique sont reliées à une ligne coplanaire à propagation dissymétrique par deux couples de diodes. Ce dispositif qui est constitué en entrée par une ligne microstrip (ou à fente) et en sortie par une ligne coplanaire permet de générer des harmoniques de rang pair du signal incident.

Ce circuit, simple à réaliser présente par contre l'inconvénient de ne pouvoir être utilisé dans la partie la plus basse du spectre hyperfréquence étant donné les limites de fonctionnement de la ligne microstrip ou à fente utilisée en entrée.

Le circuit hyperfréquence, faisant l'objet de la présente invention et pour lequel le doubleur de fréquence ne constitue qu'un cas particulier, permet de remédier aux inconvénients précités.

La présente invention a pour objet un dispositif hyperfréquence permettant de générer un signal constitué par les harmoniques d'ordre pair du signal incident dont l'entrée et la sortie se font en mode dissymétrique, présentant un fort taux de réjection des harmoniques d'ordre impair et du fondamental et pouvant fonctionner dans une large bande de fréquence et notamment dans le domaine des plus basses fréquences du spectre hyperfréquence.

Un autre objet de la présente invention est de réaliser un dispositif hyperfréquence permettant de générer l'harmonique d'ordre 2n du signal incident avec un fort taux de rejection des harmoniques impairs, des harmoniques pairs d'ordre différent de 2n et du fondamental.

Un autre objet de la présente invention d'un dispositif hyperfréquence particulièrement simple générant les harmoniques d'ordre pair du signal incident que sa réalisation plane permet d'utiliser dans un système intégré micro-onde.

L'objet de la présente invention présente également l'avantage d'un rendement de conversion optimum, constant sur la bande de fréquence d'utilisation.

L'objet de la présente invention présente également l'avantage d'une bonne linéarité de phase pour un signal incident modulé en fréquence.

Le dispositif hyperfréquence à large bande, objet de la présente invention, permettant de générer un signal composé des harmoniques pairs du signal incident, comprend un diviseur équiphase, une ligne coplanaire, une ligne à fente, deux couples d'éléments non linéaires reliant la ligne coplanaire à la ligne à fente, et est principalement caractérisé en ce que :

— le diviseur est constitué par une première et une deuxième lignes coplanaires ayant un plan conducteur commun ;

— une troisième et une quatrième lignes coplanaires ayant un plan conducteur commun, ces lignes

2

**0 078 188**

étant respectivement alimentées par la première et deuxième lignes coplanaires constituant le diviseur ;

— une première et une deuxième lignes à fente ayant un plan conducteur commun constituant ainsi une ligne coplanaire ;

— un premier et un deuxième couples d'éléments non linéaires reliant les lignes coplanaires aux lignes à fente et générant un signal à mode de propagation dissymétrique des harmoniques d'ordre pair à partir d'un signal incident.

La présente invention sera mieux comprise à la lecture de la description détaillée faite ci-après avec référence aux dessins ci-annexés qui représentent :

Figures 1a et 1b la structure d'une ligne de propagation à fente et d'une ligne de propagation coplanaire respectivement ;

Figure 2 le principe général d'un dispositif hyperfréquence selon l'invention ; et

Figure 3 un mode de réalisation du dispositif hyperfréquence selon l'invention.

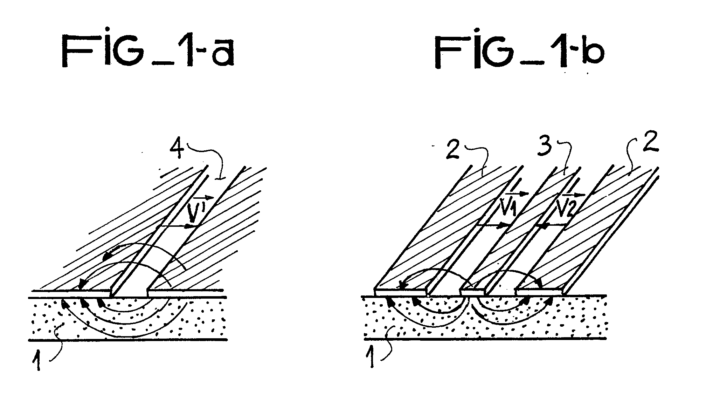

La figure 1a représente la structure d'une ligne de propagation à fente formée par deux conducteurs dessinant une fente 4 laissant apparaître le substrat 1 portant les deux conducteurs. La propagation est du type symétrique. Le vecteur V′ représente la différence de potentiel développée aux bornes de la fente 4.

La figure 1b représente la structure d'une ligne de propagation coplanaire portée par un substrat de matériau diélectrique 1 et comportant un conducteur 3 encadré par deux plans de masse 2. La propagation est du type dissymétrique. Les composantes du champ électrique sont symétriques par rapport au conducteur central 3 et la ligne coplanaire peut être considérée comme étant constituée de deux lignes à fente couplées, telles que celle illustrée par la figure 1a. Les vecteurs V1 et V2 représentent la différence de potentiel sur chacune des lignes à fente.

L'objet de la présente invention ne présente pas l'inconvénient du dispositif de l'art antérieur puisque l'entrée et la sortie du dispositif hyperfréquence se font sur une ligne coplanaire qui se prête mieux à la réalisation de circuits intégrés micro-ondes et dont l'excitation à partir des lignes coaxiales existantes s'effectue très facilement sur une grande largeur de bande. L'objet de la présente invention permet de générer les harmoniques pairs du signal incident. Complété par un circuit de filtrage il peut constituer un doubleur de fréquence ou d'une façon plus générale générer l'harmonique d'ordre 2n du signal incident appliqué à l'entrée, avec un fort taux de réjection des autres harmoniques pairs, des harmoniques impairs et du fondamental.

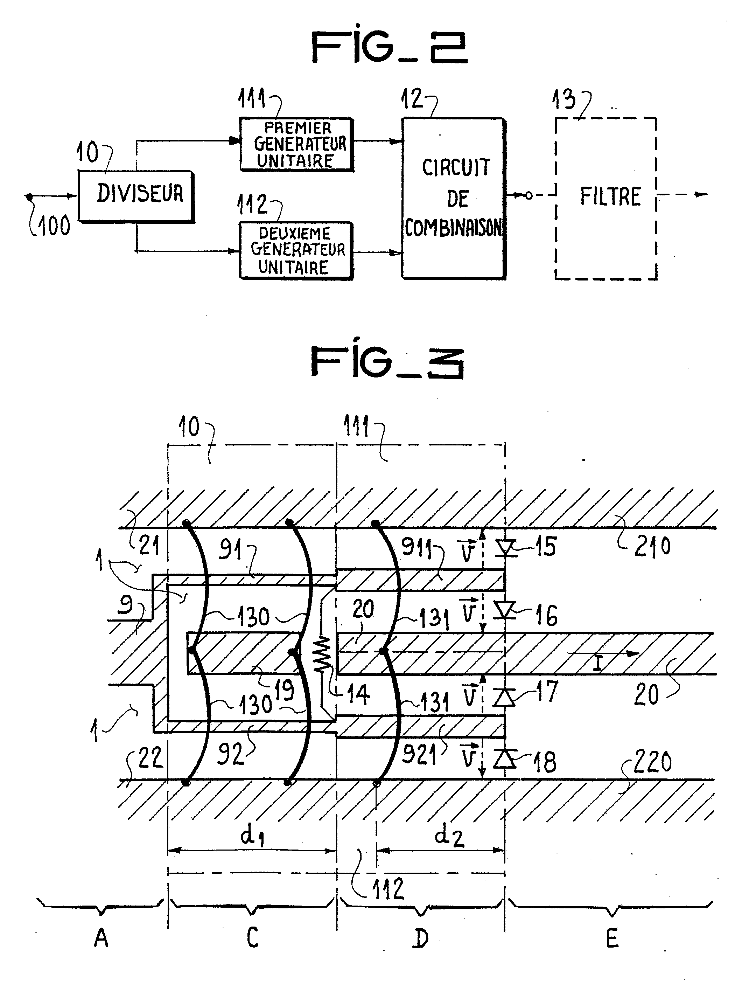

La figure 2 représente le principe général du dispositif hyperfréquence selon l'invention. Le signal incident est appliqué à l'entrée 100 d'un diviseur hyperfréquence équiphase 10 dont chacune des deux sorties alimente un circuit hyperfréquence 111, respectivement 112, du type dissymétrique/symétrique générant les harmoniques d'ordre pair du signal incident. Les sorties symétriques des circuits hyperfréquences 111 et 112 sont combinées dans un circuit 12 dont la sortie est du type dissymétrique et délivre un signal composé des harmoniques pairs du signal incident.

Ce circuit de combinaison 12 peut être suivi d'un circuit de filtrage 13 de l'harmonique 2n.

La figure 3 représente le schéma détaillé d'un mode de réalisation non limitatif du dispositif hyperfréquence selon l'invention.

Ce dispositif, réalisé sur un substrat de matériau diélectrique 1, se compose de quatre parties A, C, D, E. La partie A formant l'entrée du dispositif présente un mode de propagation du type dissymétrique, par exemple une ligne coplanaire comme dans le mode de réalisation représenté par la figure 1b. Cette ligne coplanaire d'entrée se compose d'un conducteur central 9 encadré par deux conducteurs 21 et 22, formant plans de masse.

Le conducteur central 9 se partage en deux conducteurs 91 et 92 encadrant un plan de masse 19, rendu équipotentiel avec les conducteurs 21 et 22 formant plan de masse grâce aux courts circuits 130. Le conducteur 91, respectivement 92, forme avec les plans de masse 21, respectivement 22, et 19 une ligne coplanaire.

Le circuit diviseur équiphase désigné par les références 10 dans la figure 2 et C dans la figure 3 est donc constitué, dans le mode de réalisation de la figure 3, par un Té de Wilkinson constitué par les deux lignes coplanaires décrites ci-dessus et comprenant le conducteur 91, respectivement 92, encadré par les plans de masse 21, respectivement 22, et 19. Les extrémités des conducteurs centraux 91 et 92 sont raccordées par l'intermédiaire de la résistance d'adaptation 14, à la distance $d_1 = \lambda m/4$, du conducteur central 9, $\lambda m$ étant la longueur d'onde moyenne de la bande de fonctionnement d'entrée du dispositif hyperfréquence. Le Té de Wilkinson est ici à un tronçon, de longueur $d_1 = \lambda m/4$.

Pour augmenter la largeur de bande du dispositif, on peut utiliser de façon avantageuse, un Té de Wilkinson du type coplanaire constitué de plusieurs tronçons de ligne $\lambda m/4$.

Les circuits hyperfréquence, désignés respectivement par les références 111 et 112 dans la figure 2 et permettant de générer à partir d'un signal incident un signal ne comportant que ses harmoniques pairs, sont respectivement constitués dans le mode de réalisation de la figure 3, d'une partie coplanaire D et d'une partie formant ligne à fente E. L'entrée de chaque circuit hyperfréquence 111, 112 de la figure 2 est constituée par une ligne coplanaire formée d'un conducteur central 911, respectivement 921, prolongeant le conducteur central 91, respectivement 92, de la branche correspondante du Té de Wilkinson C et encadré par deux conducteurs, le plan de masse 21, respectivement 22, et le conducteur 20 disposé entre les deux conducteurs 911 et 921. La sortie est, pour chaque circuit hyperfréquence 111 et 112 de la figure

3

2, constituée par une ligne à fente formée par les conducteurs 210, respectivement 220, et 20. Selon l'exemple non limitatif de la figure 3, les conducteurs 21 formant plan de masse et 210, respectivement 22 formant plan de masse et 220, sont représentés dans le prolongement l'un de l'autre. A la jonction des lignes coplanaires D et à fente E, deux paires d'éléments non linéaires, par exemple des diodes Schottky 15, 16 et 17, 18 comme illustré dans la figure 3 génèrent les harmoniques pairs du signal incident, en l'occurence respectivement le signal en sortie de chaque branche du Té diviseur équiphase de Wilkinson. Les diodes de chaque paire 15, 16 respectivement 17, 18 sont disposées tête-bêche l'une par rapport à l'autre entre le conducteur central 911, respectivement 921, de la ligne coplanaire D et le plan ou conducteur de masse 21 et 20, respectivement 20 et 22, les deux paires de diodes ayant le même sens l'une par rapport à l'autre.

Les conducteurs 210 et 20, respectivement 20 et 220, forment une ligne à fente, si l'on considère chaque circuit séparément. Le circuit de combinaison désigné sous la référence 12 dans la figure 3 est constitué par ces mêmes conducteurs 210, 20, 220 qui, ensemble, constituent une ligne coplanaire dont la propagation est du type dissymétrique et qui forme la sortie du dispositif selon l'invention, les conducteurs 210 et 220 étant alors les plans de masse de la ligne coplanaire de sortie.

Le signal de sortie est disponible en dissymétrique sur cette ligne. Des courts-circuits 131 entre les conducteurs 21, 20 et 22, disposés sur la partie D à une distance $d_2 = \lambda/8n$ en amont des diodes Schottky 15, 16, 17, 18, $\lambda$ étant la longueur d'onde du signal incident de fréquence $f_o$ appliqué à l'entrée du dispositif selon l'invention et n étant un nombre entier, empêchent la propagation de l'harmonique d'ordre 2n du signal incident vers le côté coplanaire D de chaque circuit 111 ou 112 de la figure 3 et par conséquent permettent de générer, en sortie E du dispositif selon l'invention, un signal dans lequel le niveau de la composante correspondant à l'harmonique 2n du signal incident est augmenté par rapport à celui des autres harmoniques pairs qui le composent.

Le principe de fonctionnement du dispositif selon l'invention est le suivant :

On admet que la tension développée aux bornes de chaque diode 15, 16, 17 ou 18 est de la forme :

$$v = Vo \cos 2\,\pi f_{0t}$$

où $f_o$ est la fréquence fondamentale du signal incident. La différence de potentiel est représentée aux bornes de chaque diode par le vecteur v sur la figure 3.

La caractéristique de la diode Schottky, élément non linéaire utilisé dans le mode de réalisation de la figure 4, peut être approchée par l'équation :

$$i_j = Is[\exp(\alpha v_T) - 1\,]$$

donnant la valeur du courant $i_j$ circulant dans la diode Schottky, $V_T$ étant égal à v pour les diodes 15 et 18 et à $(-v)$ pour les diodes 16 et 17, et j prenant respectivement les valeurs 1, 2, 3, 4 pour les diodes 15, 16, 17, 18 respectivement.

Le courant 1 circulant dans le conducteur central 20 de la ligne coplanaire E en sortie du dispositif selon l'invention est égal à :

$$I = i_1 + i_2 + i_3 + i_4$$

Par conséquent :

$$I = 2\,Is[\exp(\alpha v) + \exp(-\alpha v) - 2]$$

ou encore :

$$I = 4\,Is[\mathrm{ch}\,(\alpha v) - 1\,] \qquad (1)$$

avec

$$v = Vo \cos 2\,\pi f_{0t}$$

Si on décompose l'expression (1) ci-dessus en série de Fourier, on obtient des termes de la forme

$$I_k \cos (2\,k \cdot 2\,\pi f_{0t})$$

$$I = \sum_k I_k \cos (2\,k \cdot 2\,\pi f_{0t})$$

Ceci correspond donc bien à un dispositif générant en mode dissymétrique des harmoniques d'ordre pair à partir d'un signal hyperfréquence incident de fréquence $f_o$.

Le court-circuit disposé à la distance $d_2 = \lambda/8n$ des éléments non linéaires, du côté coplanaire, permet de ramener une impédance infinie aux bornes de chaque paire d'éléments à la fréquence $f = 2nf_0$, donc pour l'harmonique 2n du signal incident, ce qui augmente le niveau de l'harmonique 2n en empêchant sa propagation vers l'entrée du dispositif.

La détermination optimale des largeurs et des longueurs des différentes zones conductrices est à la portée de l'homme de l'art et permettra d'obtenir cette caractéristique dans une gamme de fréquence très large.

Le mode de réalisation décrit dans la figure 3 n'est pas limitatif. Les entrées et sorties peuvent par exemple ne pas être coplanaires mais coaxiales ou autre. On peut également utiliser par exemple un circuit diviseur équiphase différent du Té de Wilkinson à un ou plusieurs tronçons de longueur λm/4 décrit dans la présente demande, et en particulier, on peut utiliser un anneau hybride ou bien une simple division de lignes de propagation (fonction en Té). De même on pourrait utiliser des éléments non linéaires différents des diodes Schottky du mode de réalisation de la figure 3.

La largeur de bande du dispositif hyperfréquence objet de la présente invention est en pratique limitée par :
— la largeur de bande du circuit diviseur utilisé ;
— le taux d'ondes stationnaires à l'entrée et à la sortie lié d'une part à la technologie utilisée pour les surfaces conductrices qui doivent être bien isolées et d'autre part à la qualité des éléments semiconducteurs utilisés, les éléments parasites limitant la largeur de bande du circuit ;
— dans le cas du mode de réalisation de la figure 3, la définition du circuit de combinaison qui ramène en parallèle sur chacune des paires de diodes une impédance purement réactive :

$$Zs = jZ_{14} \, tg \, \frac{\omega_0 \, d2}{V_{14}} = jZ_{24} \, tg \, \frac{\omega_0 \, d2}{V_{24}}$$

où $Z_{14}$ et $Z_{24}$ sont les impédances caractéristiques des lignes à fente constituées par les conducteurs 210, 20 et 220, 20 respectivement, $V_{14}$ et $V_{24}$ étant la vitesse de propagation de ces deux lignes, $\omega_0$ la pulsation du signal incident et d2 la distance λ/8n.

La qualité de rendement de conversion du dispositif hyperfréquence selon l'invention dépend de la puissance du signal incident appliqué à l'entrée.

La présente invention est applicable aux systèmes hyperfréquences nécessitant une transposition de la gamme de fréquence.

## Revendications

1. Dispositif hyperfréquence à large bande permettant de générer un signal composé des harmoniques pairs du signal incident, comprenant un diviseur équiphase, une ligne coplanaire, une ligne à fente, deux couples d'éléments non linéaires reliant la ligne coplanaire à la ligne à fente, caractérisé en ce que :
— le diviseur (10) est constitué par une première (91, 21, 19) et une deuxième (92, 22, 19) lignes coplanaires ayant un plan conducteur commun (19) ;
— une troisième (911, 21, 20) et une quatrième (921, 22, 20) lignes coplanaires ayant un plan conducteur commun (20), ces lignes étant respectivement alimentées par la première et deuxième lignes coplanaires constituant le diviseur (10) ;
— une première (20, 210) et une deuxième (20, 220) lignes à fente ayant un plan conducteur commun constituant ainsi une ligne coplanaire ;
— un, premier (15, 16) et un deuxième (17, 18) couple d'éléments non linéaires reliant les lignes coplanaires aux lignes à fente et générant un signal à mode de propagation dissymétrique des harmoniques d'ordre pair à partir d'un signal incident.

2. Dispositif hyperfréquence selon la revendication 1, caractérisé en ce qu'il comprend un circuit de filtrage de l'harmonique 2n du signal incident.

3. Dispositif hyperfréquence selon l'une quelconque des revendications 1 et 2, caractérisé en ce que le circuit diviseur équiphase (10) est un Té de Wilkinson.

4. Dispositif hyperfréquence selon l'une quelconque des revendications 1 et 2, caractérisé en ce que le circuit diviseur équiphase (10) est une simple jonction en Té.

5. Dispositif hyperfréquence selon l'une quelconque des revendications 1 et 4, caractérisé en ce que les deux couples d'éléments non linéaires sont chacune constituée par deux diodes Schottky (15, 16 ; 17, 18).

6. Dispositif hyperfréquence selon les revendications 1, 3, 5, caractérisé en ce que le dispositif étant réalisé sur un substrat diélectrique avec une ligne d'entrée coplanaire constituée, entre un premier et un deuxième plans de masse (21, 22) équipotentiels, d'un conducteur central (9), ledit conducteur central (9) se divise en un premier et un deuxième conducteur (91, 92) de part et d'autre d'un troisième plan de masse (19) rendu équipotentiel avec les premier et deuxième plans de masse (21, 22) par des courts-circuits (130), le premier, respectivement deuxième, conducteur (91, 92) formant avec ledit troisième plan de masse (19) et le premier, respectivement deuxième, plan de masse (21, 22) une ligne coplanaire, lesdits premier et deuxième conducteurs (91, 92) étant interconnectés en leur extrémité par l'intermédiaire d'une résistance (14), et se prolongeant chacun au-delà de ladite résistance (14), par un conducteur (911, 921) de part et d'autre d'un quatrième plan de masse (20), et en ce que l'extrémité du premier conducteur de prolongement (911) est raccordée au premier plan de masse (21) par la première des diodes (15) et au quatrième plan de masse (20) par la seconde (16) diode et l'extrémité du deuxième conducteur de prolongement (921) est raccordée au quatrième plan de masse (20) par la troisième des diodes (17) et au deuxième plan de masse (22) par la quatrième des diodes (18), les première et deuxième, respectivement troisième et quatrième, diodes étant montées anti-parallèles, et lesdits premier, deuxième et quatrième plans de masse se prolongeant au-delà des deux couples de diodes Schottky pour former la ligne coplanaire de sortie dont le conducteur central est constitué par ledit quatrième plan de masse (20).

7. Dispositif hyperfréquence selon la revendication 6, caractérisé en ce que le filtrage de l'harmonique 2n est assuré par des courts-circuits (131) entre les premier, deuxième et quatrième plan de masse à une distance $\lambda/8n$ en amont des diodes Schottky, $\lambda$ étant la longueur d'onde du signal incident.

8. Utilisation d'un dispositif selon l'une quelconque des revendications 1 à 7 dans un système hyperfréquence intégré.


## Claims

1. Wide-band microwave device for generating a signal composed of even harmonics of the incident signal, this device comprising an equiphase divider, a coplanar line, a slit line, two pairs of non-linear elements for connecting the coplanar line to the slit line, characterized in that
— the divider (10) is constituted by a first (91, 21, 19) and a second coplanar line (92, 22, 19) having a common conductive plane (19) ;
— a third (911, 21, 20) and a fourth coplanar line (921, 22, 20) are provided having a common conductive plane (20), these lines being respectively fed by the first and the second coplanar line constituting the divider (10) ;
— a first (20, 210) and a second slit line (20, 220) is provided having a common conductive plane which thus constitutes a coplanar line ;
— a first (15, 16) and a second pair (17, 18) of non-linear elements is provided for connecting the coplanar lines to the slit lines and for generating a signal having an asymmetric propagation mode of the even order harmonics out of the incident signal.

2. A microwave device according to claim 1, characterized in that it comprises a circuit for filtering the harmonic 2n from the incident signal.

3. A microwave device according to any one of claims 1 and 2, characterized in that the equiphase divider circuit (10) is a Wilkinson-type T.

4. A microwave device according to any one of claims 1 and 2, characterized in that the equiphase divider circuit (10) is a simple T-junction.

5. A microwave device according to any one of claims 1 and 4, characterized in that the two pairs of non-linear elements are each constituted by two Schottky-diodes (15, 16 ; 17, 18).

6. A microwave device according to claims 1, 3, 5, characterized in that the device is realized on a dielectric substrate with a coplanar input line constituted between first and second equipotential mass planes (21, 22) by a central conductor (9) which is split into a first and a second conductor (91, 92) on both sides of a third mass plane (19) which is rendered equipotential with the first and the second mass plane (21, 22) by short circuits (130), the first and the second conductor (91, 92) building up a coplanar line with the third mass plane (19) and the first and second mass plane (21, 22) respectively, said first and second conductors (91, 92) being interconnected at their ends via a resistor (14) and each extending beyond said resistor (14) to a conductor (911. 921) situated on either side of the fourth mass plane (20), and that the end of the first extension conductor (911) is connected to the first mass plane (21) via the first one of the diodes (15) and to the fourth mass plane (20) via the second diode (16), whereas the end of the second extension conductor (921) is connected to the fourth mass plane (20) via the third one of the diodes (17) and to the second mass plane (22) via the fourth diode (18), the first and the second diodes and the third and the fourth diodes respectively being connected antiparallelly, the first, second and fourth mass plane extending beyond the two pairs of Schottky diodes in order to constitute the coplanar output line, the central conductor of which is constituted by said fourth mass plane (20).

7. A microwave device according to claim 6, characterized in that the filtering of the harmonic 2n is obtained by short-circuits (131) between the first, second and fourth mass planes at a distance $\lambda/8n$ upstream of the Schottky diodes, $\lambda$ being the wave length of the incident signal.

8. The use of a device according to any one of claims 1 to 7 in an integrated microwave system.


## Patentansprüche

1. Mikrowellen-Breitbandvorrichtung zur Erzeugung eines Signals, das aus geradzahligen Harmonischen des einfallenden Signals zusammengesetzt ist, mit einem Gleichphasenteiler, einer koplanaren Leitung, einer Schlitzleitung, zwei Paaren nicht-linearer Elemente, mit denen die koplanare Leitung an die Schlitzleitung angeschlossen ist, dadurch gekennzeichnet, daß

— der Teiler (10) aus einer ersten (91, 21, 19) und einer zweiten koplanaren Leitung (92, 22, 19) besteht, die eine gemeinsame leitende Ebene (19) besitzen,

— eine dritte (911, 21, 20) und eine vierte koplanare Leitung (921, 22, 20) vorgesehen sind, die eine gemeinsame leitende Ebene (20) besitzen und aus der ersten bzw. zweiten, den Teiler (10) bildenden koplanaren Leitung gespeist werden,

— eine erste (20, 210) und eine zweite Schlitzleitung (20, 220) vorgesehen sind, die eine gemeinsame leitende Ebene besitzen, die somit eine koplanare Leitung bildet,

— und ein erstes (15, 16) und ein zweites Paar nicht-linearer Elemente (17, 18) vorhanden sind, die die koplanaren Leitungen an die Schlitzleitungen anschließen und ein Signal im unsymmetrischen Fortpflanzungsmodus der Harmonischen geradzahliger Ordnung ausgehend vom einfallenden Signal erzeugen.

2. Mikrowellenvorrichtung nach Anspruch 1, dadurch gekennzeichnet, daß sie einen Filterkreis zur Ausfilterung der Harmonischen 2n des einfallenden Signals enthält.

3. Mikrowellenvorrichtung nach einem beliebigen der Ansprüche 1 und 2, dadurch gekennzeichnet, daß der Gleichphasenteilerkreis (10) ein T-Kreis vom Wilkinson-Typ ist.

4. Mikrowellenvorrichtung nach einem beliebigen der Ansprüche 1 und 2, dadurch gekennzeichnet, daß der Gleichphasenteilerkreis (10) eine einfache T-Verbindung ist.

5. Mikrowellenvorrichtung nach einem beliebigen der Ansprüche 1 bis 4, dadurch gekennzeichnet, daß die beiden Paare nichtlinearer Elemente je aus zwei Schottky-Dioden (15, 16 ; 17, 18) bestehen.

6. Mikrowellenvorrichtung nach den Ansprüchen 1, 3, 5, dadurch gekennzeichnet, daß sie auf einem dielektrischen Substrat mit einer koplanaren Eingangsleitung aufgebaut ist, die zwischen einer ersten und einer zweiten zueinander äquipotentialen Masse-ebene (21, 22) von einem zentralen Leiter (9) gebildet wird, der sich zu beiden Seiten einer dritten Masseebene (19), die über Kurzschlüsse (130) auf dasselbe Potential wie die beiden ersten Masseebenen (21, 22) gebracht ist, in einen ersten und einen zweiten Leiter (91, 92) aufteilt, wobei der erste bzw. zweite Leiter (91, 92) mit der dritten Masseebene (19) und der ersten bzw. zweiten Masseebene (21, 22) eine koplanare Leitung bildet und der erste (91) und der zweite Leiter (92) an ihren Enden über einen Widerstand (14) miteinander verbunden sind, sowie jenseits des Widerstands (14) in je einen Leiter (911, 921) zu beiden Seiten einer vierten Masseebene (20) übergehen, und daß das Ende des ersten dieser letztgenannten Leiter (911) mit der ersten Masseebene (21) über die erste der Dioden (15) und mit der vierten Masseebene (20) über die zweite Diode (16) verbunden ist, während das Ende des zweiten dieser letztgenannten Leiter (921) mit der vierten Masseebene (20) über die dritte Diode (17) und mit der vierten Masseebene (22) über die vierte Diode (18) verbunden ist, wobei die erste und zweite Diode bzw. die dritte und vierte Diode in Antiparallelschaltung vorliegen und die erste, zweite und dritte Masseebene jenseits der beiden Paare von Schottky-Dioden in die koplanare Ausgangsleitung übergehen, deren zentraler Leiter aus der vierten Masseebene (20) besteht.

7. Mikrowellenvorrichtung nach Anspruch 6, dadurch gekennzeichnet, daß die Filterung der Harmonischen 2n durch Kurzschlüsse (131) zwischen der ersten, zweiten und vierten Masseebene in einem Abstand von $\lambda/8n$ vor den Schottky-Dioden bewirkt wird, wobei $\lambda$ die Wellenlänge des einfallenden Signals ist.

8. Verwendung einer Vorrichtung nach einem beliebigen der Ansprüche 1 bis 7 in einem integrierten Mikrowellensystem.

7

# FIG_1-a

# FIG_1·b

# FIG_2

# FIG_3